# EUROPÄISCHE PATENTSCHRIFT

(11) **EP 3 289 525 B1**
(45) Veröffentlichungstag und Bekanntmachung des Hinweises auf die Patenterteilung: **14.10.2020**
(21) Anmeldenummer: 16721111.9
(22) Anmeldetag: 27.04.2016
(51) Int. Cl.: G06K 19/077, B60K 37/00, G05G 1/00, H03K 17/972

(54) **BEDIENSYSTEM FÜR EIN KRAFTFAHRZEUG**
CONTROL SYSTEM FOR A MOTOR VEHICLE
SYSTEME DE COMMANDE POUR VEHICULE AUTOMOBILE

(30) Priorität: 28.04.2015 DE 102015005341; 01.06.2015 DE 102015007108
(43) Veröffentlichungstag der Anmeldung: 07.03.2018
(73) Patentinhaber: KOSTAL Automobil Elektrik GmbH & Co. KG, 58513 Lüdenscheid (DE)
(72) Erfinder: MAIER, Oliver, 57439 Attendorn (DE); SCHIRP, Christian, 44789 Bochum (DE); SCHRÖDER, Stefan, 58509 Lüdenscheid (DE)
(74) Vertreter: Kerkmann, Detlef
(86) Internationale Anmeldenummer: PCT/EP2016/059416
(87) Internationale Veröffentlichungsnummer: WO 2016/174097

(56) Entgegenhaltungen:
- WO-A2-2007/048054
- DE-A1- 10 060 981
- DE-A1- 10 252 689
- DE-A1- 19 839 811
- DE-A1- 19 841 738
- DE-A1- 19 955 070
- DE-A1-102010 010 574
- DE-B3- 10 244 304
- DE-U1- 29 515 351
- US-A1- 2003 016 136
- US-A1- 2004 056 781
- US-A1- 2010 079 289
- US-A1- 2014 289 438
- US-B1- 6 812 838

## Beschreibung

Die Erfindung betrifft ein Bediensystem mit mehreren Schaltern, die jeweils eine Schalterbasis, einen Kappenträger und eine Schalterkappe aufweisen, wobei die Schalterkappen austauschbar auf den Kappenträgern verschiedener Schalter anbringbar sind, sowie ein Verfahren zum Betreiben des Bediensystems in einem Kraftfahrzeug.

Durch die Virtualisierung vieler Bedienelemente in einem Kraftfahrzeug, also die Verlagerung von Schaltern, Drehreglern etc. auf Displays, geht dem Kraftfahrzeug ein Stück Authentizität verloren. Es wird versucht, diesem Verlust durch den Einsatz künstlicher Haptik oder einer Überladung der angezeigten Grafikelemente mit Details entgegenzuwirken. Letztlich bleibt das Nutzergefühl jedoch "flach".

Unbestreitbarer Vorteile der displaybasierten Bedienkonzepte sind die leichte Austausch-, Erweiter-, und Individualisierbarkeit, die sich mit physisch gebundenen Bedienelementen nur mit hohem Aufwand erzeugen lassen.

Vorgeschlagen wird im Folgenden ein Bediensystem, das zumindest teilweise die Nachteil der "echten" Schalter, nämlich die fehlende Individualisierbarkeit und Anpassungsfähigkeit behebt.

Zur Vereinfachung der Fertigung, wie auch zur, im Sinne einer Prozesskette, späteren Individualisierbarkeit sind Schaltersysteme mit einer einzigen Art von Schaltern bekannt, die mit unterschiedliche Schalterkappen versehen sind. Im Prinzip ist jede Computertastatur solchermaßen aufgebaut. Allerdings ist bei Computertastaturen der Austausch einzelner Schalterkappen oder gar die Zuweisung neuer Funktionen an Schalter mit ausgetauschten Schalterkappen im Allgemeinen nicht vorgesehen.

Aus der deutschen Patentanmeldung DE 102 52 689 A1 ist eine Bedienvorrichtung für ein Kraftfahrzeug mit mindestens zwei Bedienelementeinheiten und einer Halteeinheit bekannt, wobei die Bedienelementeinheiten bezüglich der Halteeinheit frei konfigurierbar sind. Die Bedienelementeinheiten umfassen gemäß der Beschreibung eine Deckplatte, auf deren Oberseite ein Bedienelement, beispielsweise ein Dreh-/Drücksteller oder Schalter angebracht ist, und auf deren Rückseite eine Steuerschaltung angeordnet ist, die unterschiedliche elektronische Bauelemente umfasst und mit dem Bedienelement verbunden ist. Von dem Bedienelement erhält die Steuerschaltung der vorgenommenen Betätigung desselben entsprechende Steuersignale.

Die Bedienelementeinheiten übertragen neben Signalen über ihre Betätigung auch Signale über ihre Identität an eine Steuervorrichtung, so dass die Steuervorrichtung die erhaltenen Betätigungssignale einer bestimmten Bedienelementeinheit zuordnen kann. Die Bedienelementeinheit kann dadurch an der Halteeinheit an unterschiedlichen Stellen eingesetzt werden, so dass ein Benutzer individuell nach eigenen Bedürfnissen die Anordnung der einzelnen Bedienelemente zueinander selbst festlegen kann.

Die Übertragung von Signalen zwischen den Bedienelementeinheiten und der Steuervorrichtung kann drahtgebunden, etwa über ein Bussystem, optisch oder über ein Funksystem erfolgen. In jedem Fall benötigt die Schaltungsanordnung aber eine Stromversorgung, so dass beim Austausch der Positionen von Bedienelementeinheiten elektrische Verbindungen, etwa über Stecker-/Buchsenverbindungen zu trennen beziehungsweise herzustellen sind.

Nachteilig dabei ist, dass solche zur Konfiguration erforderlichen Eingriffe in das elektrische System viele Nutzer davon abhalten können, Änderungen an der Bedienvorrichtung vorzunehmen, oder aber sie veranlassen können, solche Änderungen auf ein Minimum zu beschränken. Grundsätzlich ist auch nicht auszuschließen, dass unvorsichtig vorgenommene Änderungen an dem Bediensystem Störungen verursachen, etwa wenn elektrische Steckverbindungen nicht sorgfältig hergestellt werden oder wenn elektrostatische Entladungen über freiliegende Steckverbindungen an eine Steuerungselektronik gelangen.

Es stellte sich daher die Aufgabe eine flexibel anpassbare Bedienvorrichtung zu schaffen, bei der Änderungen der Konfiguration auf einfache Weise erfolgen können, und wobei die Gefahr von Funktionsstörungen durch vorgenommene Anpassungen sehr gering ist.

Aus den Druckschriften US 2004 0056781 und US 2014 0289438 ist jeweils ein Bediensystem bekannt, bei der auswechselbare Schalter mittels RFID-Transponder identifizierbar sind. Zur Anpassung muss allerdings jeweils ein komplettes Bedienelement (Schalter) ausgewechselt werden, wobei auch elektrische Verbindungen getrennt und neu hergestellt werden müssen. Diese Erfordernisse bedingen einen relativen hohen Aufwand damit auch höhere Kosten.

Die Erfindung ist durch die unabhängigen Ansprüche definiert. Bevorzugte Ausführungsbeispiele gehen aus den abhängigen Ansprüchen hervor.

Der Begriff Schalter soll in dem vorliegenden Dokument weit ausgelegt verstanden werden und sowohl Ein- und Ausschalter, Wechselschalter, sowie auch nur während der Zeit einer Betätigung öffnende oder schließende Tastschalter umfassen. Der Kappenträger ist in all diesen Fällen ein beweglich gegen die Schalterbasis angeordnetes Element, welches einen Teil der Schaltermechanik ausbildet. Der Schalter kann damit beispielsweise einen Druckschalter oder Wippschalter ausbilden, wobei im zweiten Fall der Kappenträger zugleich ganz oder teilweise die Schaltwippe des Wippschalters ausbilden kann.

Darüber hinaus kann der Schalter auch als Berührschalter ausgeführt sein, der keine mechanisch beweglichen Teile aufweist und die Berührung einer Schalterkappe, beispielsweise durch eine kapazitive Sensorik erfasst. In diesem Fall dient der Kappenträger lediglich als ein Halteelement zur Befestigung der Schalterkappe und ist selbst gegen die Schalterbasis mechanisch unbeweglich angeordnet.

Das hier beschriebene Bediensystem weist mehrere, also mindestens zwei Schalter auf, wobei die Schalter entweder alle von gleicher Art sein können, oder auch verschiedenen Schaltertypen im vorgenannten Sinne angehören können. Vorausgesetzt wird lediglich, dass die Schalter Schalterkappen aufweisen, die gegeneinander austauschbar an den Schaltern angeordnet sind.

Einzelne Schalter können im Falle einer Minderbestückung auch mit Blindkappen verschlossen sein, so dass etwa durch den Kauf weiterer Schalterkappen auch nach Auslieferung des Fahrzeuges an den Kunden Funktionen nachrüstbar sind. Die Blindkappen können ohne einen RFID-Transponder hergestellt sein, oder aber einen RFID-Transponder aufweisen, dessen codierte Information dem Bediensystem explizit signalisiert, dass der der Schalterkappe zugeordnete Schalter funktionslos sein soll.

Um dem Nutzer auf einfache Weise eine Änderung von Funktionen sowie die Nachrüstbarkeit neuer Funktionen zu ermöglichen, sind die Schalterkappen so gestaltet, dass sie mechanisch einfach ein- und auszubauen sind. Besonders vorteilhaft ist, wenn die Schalterkappen einfach auf die Kappenträger aufrastbar sind, so dass für den Einbau oder Tausch keine besonderen Werkzeuge oder komplizierte Montagevorgänge vonnöten sind.

Besonders vorteilhaft ist es, wenn die Schalterkappen jeweils eine ihrer codierten Funktion entsprechende Beschriftung oder ein entsprechendes Symbol tragen.

Im Unterschied zum Gegenstand der zuvor bereits erwähnten Patentanmeldung DE 102 52 689 A1 wird bei der hier vorgeschlagenen Problemlösung jeweils nicht das gesamte Bedienelement sondern nur ein Designelement, nämlich die Schalterkappe, die mit einem drahtlos abfragbaren Autorisierungsgeber versehen ist, ausgetauscht.

Dieses austauschbare Element überträgt auch keinesfalls Steuersignale, die durch das Bedienelement erzeugt werden. Das eigentliche Bedienelement und seine elektrische Funktion sind und bleiben Bestandteil des Grundschalters, also der Schalterbasis und des Kappenträgers. Aus diesem Grunde ist es bei dem erfindungsgemäßen Bediensystem auch nicht erforderlich, eine elektrische Verbindung zwischen den austauschbare Elementen, also den Schalterkappen, und den Grundschaltern herzustellen.

Im Folgenden wird ein Ausführungsbeispiel der Erfindung anhand der Zeichnung dargestellt und näher erläutert. Es zeigen
- Figur 1: eine Schalterleiste,
- Figur 2: den Ablauf der Montage einer Schalterkappe,
- Figur 3: eine Schalterkappe mit eingebettetem RFID-Transponder,
- Figur 4: eine skizzenhafte Darstellung eines Bediensystems.

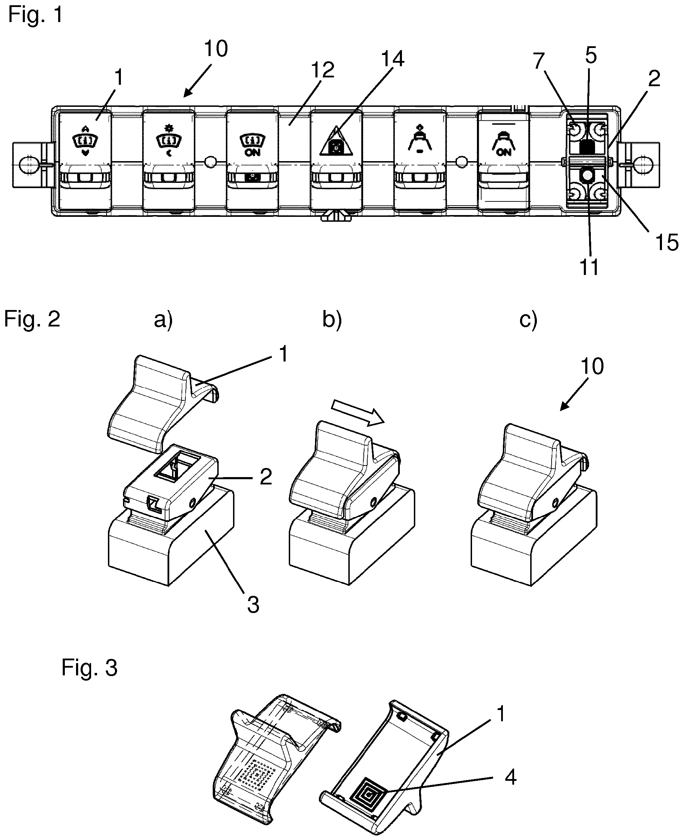

Die Zeichnung verdeutlicht schematisch den Aufbau und die Funktionsweise eines erfindungsgemäßen Bediensystems. Die Figur 1 zeigt eine Schalterleiste 12 als Teil des Bediensystems. Die Schalterleiste 12 trägt hier, rein beispielhaft, sieben nebeneinander angeordnete Schalter 10. Bei sechs dieser Schalter 10 ist jeweils eine Schalterkappe 1 erkennbar, auf deren Außenseite jeweils ein Symbol 14 aufgebracht ist, welches dem Nutzer die durch den jeweiligen Schalter 10 auslösbare Funktion erkennbar macht.

Unter dem Begriff "Schalter" sollen hier sowohl durch eine Betätigung dauerhaft ein- oder ausschaltbare Schaltelemente, als auch Schaltelemente, die nur für den Zeitraum einer manuellen Betätigung ihren Schaltzustand wechseln, also sogenannte Tastschalter, zusammengefasst werden. Die Schalter können dabei mechanische Kontakteelemente aufweisen oder auch kontaktlose Sensorberührschalter ausbilden. Hinsichtlich der erfinderischen Idee ist die Art der verwendeten Schalter 10 dabei von nebensächlicher Bedeutung.

Ein einzelner Schalter 10 der Schalterleiste 12 ist in der Figur 2 dargestellt. Bei diesem wird eine Schalterkappe 1 auf einem fest mit einer Schalterbasis 3 verbundenen Kappenträger 2 befestigt. Die Schalterkappe 1 lässt sich zur Montage seitlich auf den Kappenträger 2 aufschieben (Figuren 2a und 2b) und rastet auf diesem ein, sobald er seine vorgesehene Befestigungsposition erreicht hat (Figur 2c).

Um ein unbeabsichtigtes Herunterschieben der Schalterkappe 1 zu verhindern, kann vorgesehen sein, dass an dem Schalter 10 ein zum Wechseln der Schalterkappe 1 demontierbarer Abdeckrahmen befestigt wird, der den Schalter 10 seitlich umschließt. Der Schalterrahmen selbst, der in der Zeichnung nicht dargestellt ist, kann vorzugsweise durch eine Klipsverbindung befestigt sein, so dass er sich mit einem kleinen Schraubenzieher auf einfache Weise wieder entklipsen lässt.
In der Figur 1 ist an der rechten Schalterposition der Schalterleiste 12 ein Schalter ohne Schalterkappe abgebildet, wodurch eine Schaltmatte 15 mit vier Schaltdomen 7 als Schaltelementen erkennbar ist. Eine solche Schaltmatte 15 ermöglicht sowohl die Realisierung von Tastschaltfunktionen als auch, etwa durch eine rastende Schaltermechanik oder durch eine eine Betätigung speichernde elektronische Steuervorrichtung, die Schaffung von Ein-, Aus- oder Umschaltfunktionen.

Die Schaltmatte 15 ist auf einem, hier nicht dargestellten elektrischen Schaltungsträger angeordnet. Dieser ermöglicht auf einfache Weise im Bereich jedes Schalters 10 zusätzliche elektrische Komponenten anzuordnen, wie beispielsweise Leuchtelemente 11 zur Hinterleuchtung der zu den Schaltern 10 gehörenden Schalterkappen 1 und vor allem auch jeweils eine RFID-Lesevorrichtung 5 an jedem Schalter 10.

Die Abkürzung RFID (engl. radio-frequency identification, "Identifizierung mit Hilfe elektromagnetischer Wellen") bezeichnet eine Technologie für Sender-Empfänger-Systeme zum automatischen und berührungslosen Identifizieren von Objekten mit Radiowellen.

Ein RFID-System besteht aus einem RFID-Transponder 4 (umgangssprachlich auch RFID-Tag oder Funketikett genannt), der sich am oder im Gegenstand befindet und einen kennzeichnenden Code enthält, sowie einer RFID-Lesevorrichtung 5 zum Auslesen dieser Kennung.

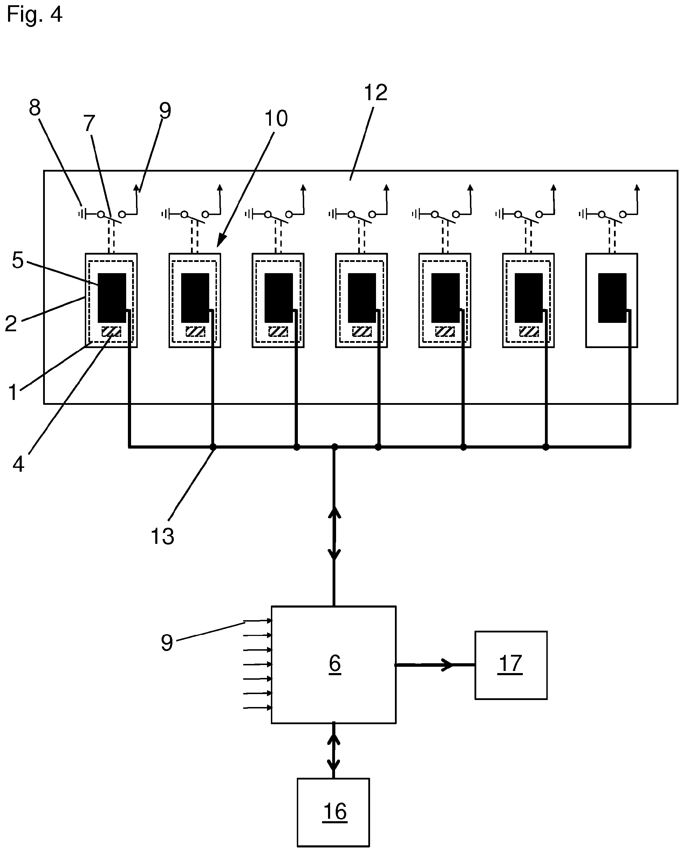

Das Auslesen geschieht durch magnetische Wechselfelder geringer Reichweite oder durch hochfrequente Radiowellen, die von einer RFID-Lesevorrichtung 5 erzeugt werden. Damit werden nicht nur Daten übertragen, sondern auch der RFID-Transponder 4 mit Energie versorgt. Die RFID-Lesevorrichtung 5 enthält eine Software (ein Mikroprogramm), die den eigentlichen Leseprozess steuert, und eine Hardware mit Schnittstellen, etwa zur Anbindung an eine zur Automobilelektronik gehörende Steuervorrichtung 6 (dargestellt in der Figur 4).

Damit ein Nutzer des Bediensystems die durch die Automobilelektronik ausführbaren Funktionen den Schaltern 10 auf einfache Weise individuell hinsichtlich Anordnung und Reihenfolge zuordnen kann, ist vorgesehen, dass an oder in jeder Schalterkappe 1 ein eindeutiges, kontaktlos auswertbares Identifizierungsmerkmal angeordnet ist, welches durch einen RFID-Transponder 4 realisiert wird.

Die Figur 3 zeigt diesbezüglich eine Schalterkappe 1, bei der ein RFID-Transponder 4, hier vereinfacht dargestellt durch eine als eckige Spirale geformte Kopplungsspule, an der Unterseite einer Schalterkappe 1 angeordnet oder in das Material der Schalterkappe 1 eingegossen ist.

RFID-Lesevorrichtungen 5 an oder in den einzelnen Schaltern 10 der Schalterleiste 12 erfassen, ob die an den Schaltern 10 angeordneten Schalterkappen 1 einen RFID-Transponder 4 aufweisen und lesen, soweit dies der Fall ist, regelmäßig die in den RFID-Transpondern 4 codierten Identifizierungsmerkmale aus. Diese Information wird einer zum Bediensystem gehörenden elektronischen Steuervorrichtung 6, die in der Figur 4 skizzenhaft dargestellt ist, zugeführt.

Der prinzipielle Aufbau und die Funktionsweise des Bediensystems soll anhand der Figur 4 näher erläutert werden. Die in der Figur 1 gegenständlich gezeigte Schalterleiste 12 ist hier noch einmal und mehr schematisch skizziert. Dargestellt sind wiederum mehrere Schalter 10 auf einer Schalterleiste 12. Jedem Schalter 10 ist jeweils eine RFID-Lesevorrichtung 5 zugeordnet, die alle über ein Bussystem 13 oder alternativ über eine Vielzahl von Einzelleitern mit einer elektronischen Steuervorrichtung 6 verbunden sind.
Die Steuervorrichtung 6 steuert die einzelnen RFID-Lesevorrichtungen 5 regelmäßig aufeinanderfolgend an, um festzustellen, ob sich ein RFID-Transponder 4 in unmittelbarer Nähe befindet und um gegebenenfalls die im RFID-Transponder 4 codierte Information auszulesen.

Diese Informationen, welche Identifizierungsmerkmale für die jeweiligen Schalter 10 und die durch die Schalter 10 auszulösenden Funktionen darstellen, werden vorzugsweise bei jedem Start des Kraftfahrzeuges von der Steuervorrichtung 6 ausgelesen. Neu hinzugekommene Funktionen oder Funktionen, die durch einen Nutzer zwischenzeitlich mittels eines Austauschs von Schalterkappen 1 auf andere Schalterpositionen gelegt wurden, werden so durch die Steuervorrichtung 6 automatisch erkannt. Die Steuervorrichtung 6 kann somit nach dem Auslesen der RFID-Transponder 4 den Schaltern 10 an jeder Schalterposition eine bei Betätigung auszulösende Funktion zuordnen.

Die Erfassung, ob ein bestimmter Schalter 10 betätigt wird oder nicht, erfolgt dagegen unabhängig vom RFID-System durch die Überwachung von konventionellen Schaltelementen 7. In der Figur 4 ist jedem Schalter 10 symbolisch ein elektrisches Schaltelement 7 zugeordnet, welches bei Betätigung eine zur Steuervorrichtung 6 führende Signalleitung 9 mit einem Massepotential 8 verbindet. Liegt auf der Signalleitung 9 eines Schalters 10 das Massepotential 8 an, so erkennt die Steuervorrichtung 6, dass der entsprechende Schalter 10 betätigt wurde. Aufgrund der zuvor ausgelesenen Information des RFID-Transponders 4 dieses Schalters 10, ordnet die Steuervorrichtung 6 der Schalterbetätigung eine auszulösende Funktion zu und veranlasst eine entsprechende Ansteuerung oder Betätigung eines Funktionselements 17. Die hier als Einzelleitungen dargestellten Signalleitungen 9 können alternativ selbstverständlich auch als ein Bussystem ausgeführt sein.

Grundsätzlich ist es nicht erforderlich, jedem einzelnen Schalter 10 eine RFID-Lesevorrichtung 5 zuzuordnen, da RFID- Lesevorrichtungen 5 oftmals auch die Informationen mehrerer RFID-Transponder 4 parallel erfassen können. In diesem Fall kann das gesamte Bediensystem, anders als in der Zeichnung dargestellt, auch mit einer einzigen RFID- Lesevorrichtung auskommen, sofern diese die Positionen der RFID-Transponder 4, etwas durch ein geeignetes Antennensystem, ortsauflösend erfassen kann, um den empfangenen identifizierenden Informationen der Schalter 10 konkrete Schalterpositionen zuzuordnen, oder durch andere Maßnahmen wie einen geführten Benutzereingriff, wie etwa eine Displayaufforderung, eine bestimmte Taste zu drücken, eine einzelne Schalterkappe 1 einer bestimmten Schalterposition zugeordnet werden kann.

Das regelmäßige Einlesen der Identifikationsmerkmale durch die mindestens eine RFID-Lesevorrichtung 5 ermöglicht es, die Zuordnung von Schaltfunktionen an Schalterpositionen durch einen einfachen Austausch von Schalterkappen 1 jederzeit leicht zu ändern.

Darüber hinaus wird es auf einfache Weise möglich, durch das Hinzufügen von Schalterkappen 1 mit neuen Identifikationsmerkmalen auch ganz neue Funktionen in ein Kraftfahrzeug einzubringen. Hierzu kann vorteilhafterweise vorgesehen sein, dass das Kraftfahrzeug über eine Datenfernverbindung 16, wie beispielsweise eine GSM- oder LTE-Verbindung, die zur Ausführung der durch einen neuen Schalter 10 aktivierbaren Funktion benötigte Software bei dessen Hersteller beziehen kann.

Eine andere Ausführungsform kann vorsehen, dass das Kraftfahrzeug ab Werk schon funktionelle Ausstattungsvarianten in der Betriebssoftware der Steuervorrichtung 6 eingebettet hat, die beim Vorhandensein von entsprechenden Identifizierungsmerkmalen in den RFID-Transpondern von Schalterkappen 1 zur Benutzung freigegeben werden.
Alternativ kann auch die Verpackung der Schalterkappe 1 einen einmalig vergebenen 2D-Barcode enthalten, der beispielsweise über ein Smartphone und dessen Internetverbindung an das Rechenzentrum des Herstellers übertragen werden kann. Die Aktivierung der entsprechenden Funktion im Kraftfahrzeug kann über dessen Internetverbindung zum Hersteller-Rechenzentrum ausgelöst werden oder es kann eine entsprechende Software an das Kraftfahrzeug übertragen werden. Die Schalterkappe 1 braucht in dieser Ausführung keine individuelle Information zu tragen, sondern lediglich das vielfach vergebene Identifikationsmerkmal der freizuschaltenden Funktion.

### Bezugszeichen

- 1: Schalterkappe(n)
- 2: Kappenträger
- 3: Schalterbasis
- 4: RFID-Transponder
- 5: RFID-Lesevorrichtung
- 6: Steuervorrichtung
- 7: Schaltdome (Schaltelemente)
- 8: Massepotential
- 9: Signalleitung
- 10: Schalter
- 11: Leuchtelemente
- 12: Schalterleiste
- 13: Bussystem
- 14: Symbol
- 15: Schaltmatte
- 16: Datenfernverbindung
- 17: Funktionselement

## Patentansprüche

1. Bediensystem mit mehreren Schaltern (10),
die jeweils eine Schalterbasis (3), einen Kappenträger (2) und eine Schalterkappe (1) aufweisen,
wobei die Schalterkappen (1) austauschbar auf den Kappenträgern (2) verschiedener Schalter (10) anbringbar sind,
**dadurch gekennzeichnet,**
**dass** die Schalterkappen (1) jeweils einen RFID-Transponder (4) aufweisen,
**dass** an den Schaltern (10) jeweils eine RFID-Lesevorrichtung (5) oder ein ortsauflösend erfassendes Antennensystem einer gemeinsamen RFID-Lesevorrichtung angeordnet ist, und
**dass** in jedem RFID-Transponder (4) jeweils eine auslesbare Information gespeichert ist, welche einer Funktion innerhalb des Bediensystems zugeordnet ist.

2. Bediensystem nach Anspruch 1, **dadurch gekennzeichnet, dass** an jedem Schalter (10) unmittelbar am oder nahe des Kappenträgers (2) oder der Schalterbasis (3) jeweils eine RFID-Lesevorrichtung (5) zum Auslesen eines RFID-Transponders (4) angeordnet ist.

3. Bediensystem nach Anspruch 1, **dadurch gekennzeichnet, dass** mehreren Schaltern (10) eine gemeinsame RFID-Lesevorrichtung (5) zugeordnet ist, welche die Anordnung mehrerer RFID-Transponder (4) ortsauflösend erfassen kann.

4. Bediensystem nach Anspruch 1, **dadurch gekennzeichnet, dass** mehreren Schaltern (10) eine gemeinsame RFID-Lesevorrichtung (5) zugeordnet ist, und dass die Steuervorrichtung (6) durch einen geführten Benutzereingriff eine einzelne Schalterkappe (1) einer bestimmten Schalterposition zuordnet.

5. Bediensystem nach Anspruch 1, **dadurch gekennzeichnet, dass** die mindestens eine RFID-Lesevorrichtung (5) elektrisch mit einer Steuervorrichtung (6) verbunden sind, die den Schaltzustand aller Schalter (10) über mindestens eine Signalleitung (9) erfasst und die Ausführung der den Schaltern (10) zugeordneten Funktionen veranlasst.

6. Bediensystem nach Anspruch 1, **dadurch gekennzeichnet, dass** zumindest einer der Schalter (10) als Tastschalter ausgebildet ist.

7. Bediensystem nach Anspruch 1, **dadurch gekennzeichnet, dass** zumindest einer der Schalter (10) als Berührschalter ausgebildet ist.

8. Bediensystem nach Anspruch 1, **dadurch gekennzeichnet, dass** jede Schalterkappe (1) ein Symbol (14) oder eine Beschriftung trägt, welches die Funktion, die durch die im RFID-Transponder (4) gespeicherte Information codiert ist, für einen Nutzer erkennbar macht.

9. Verfahren zum Betreiben eines Bediensystems in einem Kraftfahrzeug, **dadurch gekennzeichnet, dass** in dem Kraftfahrzeug ein Bediensystem nach einem der vorherigen Ansprüche bereitgestellt wird, dass eine Steuervorrichtung (6) über die RFID-Lesevorrichtungen (5) bei jedem Start des Kraftfahrzeugs die Informationen der RFID-Transponder (4) erfasst, und dass beim Erkennen einer neuen Information die dieser zugeordnete, als Ausstattungsvariante in der Betriebssoftware des Kraftfahrzeugs eingebettete Funktion durch die Steuervorrichtung (6) zur Benutzung freigegeben wird.

10. Verfahren zum Betreiben eines Bediensystems in einem Kraftfahrzeug, **dadurch gekennzeichnet, dass** in dem Kraftfahrzeug ein Bediensystem nach einem der vorherigen Ansprüche bereitgestellt wird, dass die RFID-Lesevorrichtung (5) bei jedem Start des Kraftfahrzeugs die Informationen der RFID-Transponder (4) erfasst, und dass beim Erkennen einer neuen Information eine Software für die Ausführung der dieser Information zugeordneten Funktion durch eine Steuervorrichtung (6) über eine Datenfernverbindung (16) bezogen und zur Benutzung freigegeben wird.

## Claims

1. An operating system with several; switches (10),
each having a switch base (3), a cap carrier (2) and a switch cap (1)
whereby the switch caps (1) are replaceable on the cap carriers (2) and
can be placed on different switches (10),
**characterized by the fact that,**
each of the switch caps (1) has an RFID transponder (4),
an RFID reading device (5) or a location-oriented logging antenna system of a joint RFID reading device is fitted to the switches (10),
in each RFID transponder (4) information which can be read out is stored and this information is assigned to a function within the operating system.

2. An operating system as Claim 1, **characterized by** the fact that, immediately next to or close to the cap carrier (2) or the switch base (3) an RFID reading device (5) is fitted to each switch (10) to read out an RFID transponder (4).

3. An operating system as Claim 1, **characterized by** the fact that a common RFID reading device (5) is assigned to several switches (10) and this RFID reading device (5) can log the layout of several RFID transponders (4) on a location-oriented basis.

4. An operating system as Claim 1, **characterized by** the fact that a common RFID reading device (5) is assigned to several switches (10) and, by an action carried out by the user, the controlling device (6) assigns a individual switch cap (1) to an specific switch function.

5. An operating system as Claim 1, **characterized by** the fact that at least one RFID reading device (5) is connected electrically to a control device (6) which logs the switch status of all the switches (10) via at least one signal wire (9) and initiates the execution of the functions assigned to the switches (10).

6. An operating system as Claim 1, **characterized by** the fact that at least one of the switches (10) is designed as a momentary-action switch.

7. An operating system as Claim 1, **characterized by** the fact that at least one of the switches (10) is designed as a touch switch.

8. An operating system as Claim 1, **characterized by** the fact that each switch cap (1) has a symbol (14) or lettering which makes clear for a user the function which is coded by the information stored in the RFID transponder (4).

9. A procedure for using an operating system in a motor vehicle, **characterized by** the fact that an operating system complying with one of the previous claims is provided in the motor vehicle and that, each time the motor vehicle is started, a control device (6), using the RFID reading devices (5), logs the information held in the transponders (4) and that, when new information is detected, the function assigned to this information, embedded in the operating software of the motor vehicle based on the equipment variant, is released by the control device (6) for use.

10. A procedure for using an operating system in a motor vehicle, **characterized by** the fact that an operating system complying with one of the previous claims is provided in the motor vehicle and that, each time the motor vehicle is started, the RFID reading device (5) logs the information held in the transponders (4) and that, when new information is detected, an item of software for the execution of the function assigned to this information is referred to by a control device (6) via a remote data connection (16) and is released for use.

## Revendications

1. System de commande avec plusieurs commutateurs (10)
qui présentent chacun une base de commutateur (3), un support de calotte (2) et une calotte de commutation (1),
sachant que les calottes de commutation (1) peuvent être installées de manière interchangeable sur les supports de calotte (2) de différents commutateurs (10),
**caractérisé en ce que**
les calottes de commutation (1) présentent chacune un transpondeur RFID (4),
que, sur chacun des commutateurs (10), est installé un dispositif de lecture RFID (5) ou un système d'antenne à résolution spatiale d'un dispositif de lecture RFID commun, et
que, dans chaque transpondeur RFID (4), est mémorisée une information respective lisible, qui est attribuée à une fonction à l'intérieur du système de commande.

2. System de commande selon la revendication 1,
**caractérisé en ce que**, sur chacun des commutateurs (10), directement sur ou à proximité du support de calotte (2) ou de la base de commutateur (3), est respectivement disposé un dispositif de lecture RFID (5) pour la lecture d'un transpondeur RFID (4).

3. System de commande selon la revendication 1, **caractérisé en ce qu'**un dispositif de lecture RFID (5) commun, qui peut saisir par résolution spatiale la disposition de plusieurs transpondeurs RFID, est attribué à plusieurs commutateurs (10).

4. System de commande selon la revendication 1, **caractérisé en ce qu'**un dispositif de lecture RFID (5) commun est attribué à plusieurs commutateurs (10) et que le dispositif de commande (6), par une
intervention de l'utilisateur, attribue une calotte de commutation (1) individuelle à une position de commutation déterminée.

5. System de commande selon la revendication 1,
**caractérisé en ce que** l'au moins un dispositif de lecture RFID (5) est relié électriquement à un dispositif de commande (6), qui saisit l'état de commutation de tous les commutateurs (10) sur au moins une conduite de signal (9) et provoque l'exécution des fonctions qui sont attribuées aux commutateurs (10).

6. System de commande selon la revendication 1,
**caractérisé en ce que** l'un des commutateurs (10) au moins est réalisé sous la forme d'un commutateur à touche.

7. System de commande selon la revendication 1, **caractérisé en ce que** l'un des commutateurs (10) au moins est réalisé sous la forme d'un commutateur à effleurement.

8. System de commande selon la revendication 1, **caractérisé en ce que** chaque calotte de commutation (1) porte un symbole (14) ou une inscription, qui permet à l'utilisateur de reconnaître la fonction, qui est codée par l'information mémorisée dans le transpondeur RFID (4).

9. Procédé pour l'utilisation d'un système de commande dans un véhicule automobile, **caractérisé en ce que**, dans le véhicule automobile, est disponible un système de commande selon l'une des revendications précédentes et que, lors de chaque démarrage, un dispositif de commande (6) saisit, par l'intermédiaire de dispositifs de lecture RFID (5), les informations des transpondeurs RFID (4), et que, lors de la détection d'une nouvelle information, la fonction attribuée à celle-ci, est libérée pour I*utilisation par le
dispositif de commande (6) en tant que variante d'équipement, intégrée dans le logiciel du véhicule automobile.

10. Procédé pour l'utilisation d'un système de commande dans un véhicule automobile, **caractérisé en ce que**, dans le véhicule automobile, est disponible un système de commande selon l'une des revendications précédentes, que, lors de chaque démarrage, le dispositif de lecture RFID (5) saisit, les informations des transpondeurs RFID (4), et que, lors de la détection d'une nouvelle information, un logiciel pour l'exécution de la fonction attribuée à cette information est déterminé par un dispositif de commande (6), par l'intermédiaire d'une liaison à distance de données (16), et libéré pour l'utilisation.
